# EUROPEAN PATENT APPLICATION

(11) **EP 4 742 243 A1**
(43) Date of publication of application: **13.05.2026**
(21) Application number: 25211297.4
(22) Date of filing: 27.10.2025
(51) Int. Cl.: G11C 5/04, H10W 70/63, H10W 70/65

(54) **PACKAGE SUBSTRATE AND SEMICONDUCTOR PACKAGE INCLUDING THE SAME**

(30) Priority: 07.11.2024 KR 20240156874
(71) Applicant: Samsung Electronics Co., Ltd., Suwon-si, Gyeonggi-do 16677 (KR)
(72) Inventor: PARK, Okgyeong, Suwon-si, Gyeonggi-do 16677 (KR)
(74) Representative: Kuhnen & Wacker Patent- und Rechtsanwaltsbüro PartG mbB

(57) **Abstract**

A package substrate a core having a first surface and a second surface that is opposite to the first surface in a vertical direction, the core including glass and a first recess in the first surface, a first bonding layer contacting the first surface of the core and filling the first recess, a through electrode extending from the first surface through the core in the vertical direction, the through electrode being spaced apart from the first recess in a horizontal direction, a first wiring structure on the first bonding layer and contacting the through electrode, a first insulation layer structure on the first bonding layer and partially covering the first wiring structure; and a first protective layer on the first insulation layer structure and covering an upper surface of a first portion of the first wiring structure.

## Description

### BACKGROUND

Example embodiments relate to a package substrate and a semiconductor package including the same.

As an area of a package substrate increases, warpage occurs in the package substrate, and a method of increasing the stiffness of the core is needed.

### SUMMARY

It is an aspect to provide a package substrate having enhanced electrical characteristics.

It is another aspect to provide a semiconductor package having enhanced electrical characteristics.

According to an aspect of one or more example embodiments, there is provided a package substrate comprising a core having a first surface and a second surface that is opposite to the first surface in a vertical direction, the first surface and the second surface being substantially flat, the core including glass and a first recess in the first surface; a first bonding layer contacting the first surface of the core and filling the first recess; a through electrode extending from the first surface through the core in the vertical direction, the through electrode being spaced apart from the first recess in a horizontal direction; a first wiring structure on the first bonding layer and contacting the through electrode; a first insulation layer structure on the first bonding layer and at least partially covering the first wiring structure; and a first protective layer on the first insulation layer structure and covering an upper surface of a portion of the first wiring structure.

According another aspect of one or more example embodiments, there is provided a package substrate comprising a core including glass, the core having a first surface and a second surface opposite the first surface in a vertical direction and a first recess in the first surface; a first bonding layer in the first recess, the first bonding layer including a first organic insulating material; a second bonding layer contacting the first surface of the core and an upper surface of the first bonding layer, the second bonding layer including a second organic insulating material that is different from the first organic insulating material; a through electrode extending from the first surface through the core in the vertical direction, the through electrode being spaced apart from the first recess in a horizontal direction; a first wiring structure on the first bonding layer and contacting the through electrode; a first insulation layer structure on the first bonding layer and at least partially covering the first wiring structure; and a first protective layer on the first insulation layer structure and covering an upper surface of a portion of the first wiring structure.

According to yet another aspect of one or more example embodiments, there is provided a semiconductor package comprising a package substrate including a core including glass and having a first surface and a second surface that is opposite to the first surface in a vertical direction, the first surface and the second surface being substantially flat and the core including a first recess in the first surface; a first bonding layer contacting the first surface of the core and filling the first recess; a through electrode extending from the first surface through the core in the vertical direction, the through electrode being spaced apart from the first recess in a horizontal direction; a first wiring structure on the first bonding layer and contacting the through electrode; a first insulation layer structure on the first bonding layer and at least partially covering the first wiring structure; and a first protective layer on the first insulation layer structure and covering an upper surface of a first portion of the first wiring structure; a semiconductor chip on the package substrate, the semiconductor chip including a conductive pad; a first conductive connection member contacting the conductive pad of the semiconductor chip, the conductive connection member being electrically connected to a second portion of the first wiring structure; and a molding member on the package substrate and covering the semiconductor chip and a sidewall of the first conductive connection member.

### BRIEF DESCRIPTION OF THE DRAWINGS

The above and other aspects will be more clear based on the following description in combination with the drawings, in which:
FIG. 1 is a cross-sectional view illustrating a package substrate in accordance with example embodiments;
FIGS. 2 to 6 are cross-sectional views illustrating a method of manufacturing a package substrate in accordance with example embodiments;
FIG. 7 is a cross-sectional view illustrating a package substrate in accordance with example embodiments;
FIGS. 8 to 10 are cross-sectional views illustrating package substrates in accordance with example embodiments;
FIG. 11 is a cross-sectional view illustrating a semiconductor package in accordance with example embodiments; and
FIG. 12 is a cross-sectional view illustrating an electronic device in accordance with example embodiments.

### DETAILED DESCRIPTION

Hereinafter, example embodiments will be explained in detail with reference to the accompanying drawings. It will be understood that, although the terms such as "first," "second," and/or "third" may be used herein to describe various materials, layers (films), regions, electrodes, pads, patterns, structures and processes, these materials, layers (films), regions, electrodes, pads, patterns, structures and processes should not be limited by these terms. These terms are only used to distinguish one material, layer (film), region, electrode, pad, pattern, structure and process from another material, layer (film), region, electrode, pad, pattern, structure and process. Thus, a "first" material, layer (film), region, electrode, pad, pattern, structure and process discussed below could be termed a "second" or a "third" material, layer (film), region, electrode, pad, pattern, structure and process without limiting the layer (film), region, electrode, pad, pattern, structure and/or process.

A package substrate may include a core, insulation layers on lower and upper surfaces of the core, and a wiring structure in the insulation layers. As described above, as an area of the package substrate increases, warpage may occur in the package substrate, and a method of increasing the stiffness of the core is needed.

In the package substrate in accordance with various example embodiments, recesses may be disposed on the surfaces of a core so that a contacting area between a bonding layer and the core may increase and that a bonding force between a portion of the bonding layer in the recess and the core may increase. Thus, delamination between the core and the bonding layer may be relieved so that the package may have enhanced structural stability and electrical characteristics.

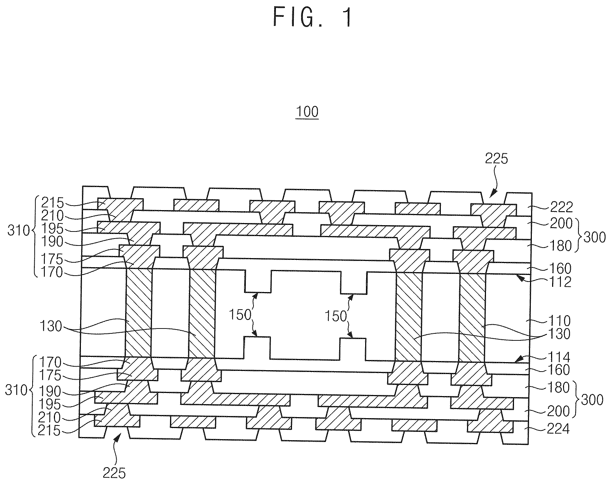

FIG. 1 is a cross-sectional view illustrating a package substrate in accordance with example embodiments.

Referring to FIG. 1, a package substrate 100 may include a core 110 having a first surface 112 and a second surface 114 that are opposite to each other in a vertical direction and that have recesses 150, a through electrode 130 extending through the core 110 in the vertical direction, first bonding layers 160 that are disposed on the first and second surfaces 112 and 114, respectively, and fill the recesses 150, insulation layer structures 300 on lower surfaces and upper surfaces of the first bonding layers 160, respectively, and a first protective layer 222 and a second protective layer 224 on lower and upper surfaces of the insulation layer structures 300, respectively, and a wiring structure 310 may be disposed between the first bonding layer 160 and each of the first and second protective layers 222 and 224.

In an example embodiment, the core 110 may include glass. In an example embodiment, the core 110 may have a thickness of about 400um to about 800um. Each of the first and second surfaces 112 and 114 may be substantially flat.

In example embodiments, a plurality of recesses 150 may be spaced apart from each other in a horizontal direction in each of the first and second surfaces 112 and 114 of the core 110. FIG. 1 shows two recesses 150 in each of the first and second surfaces 112 and 114 of the core 110. However, example embodiments are not limited to two recesses 150 and, in some example embodiments, the number of recesses 150 may be varied. The recesses 150 may be arranged by various layouts in a plan view.

Each of the recesses 150 may have a shape of, e.g., a circle, an ellipse, a polygon, a polygon with rounded corners, etc., in a plan view. In an example embodiment, a width in the horizontal direction of each of the recesses 150 may be substantially constant in the vertical direction, and thus a sidewall of each of the recesses 150 may extend in the vertical direction.

In example embodiments, the width in the horizontal direction of each of the recesses 150 may be equal to or greater than about 5um, and a depth in the vertical direction of each of the recesses 150 may be equal to or greater than about 10um. In other words, each of the recesses 150 may extend from the first or second surface 112, 114 into the core 110 to a depth equal to or greater than about 10um. As discussed above, the first bonding layer 160 may fill the recesses 150, and may fill the recesses 150 to the depth of equal to or greater than about 10um.

FIG. 1 shows an example in which the recesses 150 on the first surface 112 of the core 110 and the recesses 150 on the second surface 114 of the core 110 have the same layout. However, example embodiments are not limited thereto, and in some example embodiments, the layout of the recesses 150 on the first surface 112 may be different than the layout of the recesses 150 on the second surface 114.

FIG. 1 shows an example in which the recesses 150 in the first and second surfaces 112 and 114, respectively, of the core 110 are arranged symmetrically with respect to a line passing through a center of the core 110 in the vertical direction, and that the recesses 150 in the first and second surfaces 112 and 114, respectively, of the core 110 overlap each other in the vertical direction. However, example embodiments are not limited thereto. For example, in some example embodiments, at least one of the recesses 150 in the first surface 112 of the core 110 may not overlap the recesses 150 in the second surface 114of the core 110.

In some example embodiments, the recesses 150 may be disposed only in the first surface 112 of the core 110, or only in the second surface 114 of the core 110. In other words, in some example embodiments, the recesses 150 may be omitted from the first surface but disposed in the second surface 114, or omitted from the second surface 114 but disposed in the first surface 112.

A plurality of through electrodes 130 may be spaced apart from each other in the horizontal direction. FIG. 1 shows an example including four through electrodes 130. However, example embodiments are not limited to four through electrodes and, in some example embodiments, more or less than four through electrodes may be disposed. The through electrodes 130 may be arranged by various layouts in a plan view. In example embodiments, each of the through electrodes 130 may be spaced apart from the recesses 150 in the horizontal direction.

The through electrode 130 may include a metal, e.g., copper, aluminum, etc.

Since the recesses 150 are disposed in each of the first and second surfaces 112 and 114 of the core 110, an area of the first bonding layer 160 contacting each of the first and second surfaces 112 and 114 of the core 110 may increase. An upper surface of the first bonding layer 160 on the first surface 112 of the core 110 may be substantially flat, and a lower surface of the first bonding layer 160 on the second surface 114 of the core 110 may be substantially flat.

In an example embodiment, the first bonding layer 160 may include polymer, e.g., epoxy. Alternatively, the first bonding layer 160 may include an insulating material, e.g., Ajinomoto build-up film (ABF^{™}).

In an example embodiment, the insulation layer structure 300 may include a first insulating layer 180 and a second insulation layer 200 sequentially stacked in the vertical direction on the lower surface of the first bonding layer 160 or on the upper surface of the first bonding layer 160. However, example embodiments are not limited thereto, and in some example embodiments, the insulation layer structure 300 may include more than two insulation layers sequentially stacked in the vertical direction.

Each of the first and second insulation layers 180 and 200 may include an insulating material, e.g., ABF.

In an example embodiment, the wiring structure 310 may include a first via 170, a second via 190, and a third via 210 sequentially stacked in the vertical direction and a first wiring 175, a second wiring 195, and a third wiring 215 sequentially stacked in the vertical direction on the lower surface of the insulation layer structure 300 or on the upper surface of the insulation layer structure 300. However, example embodiments are not limited thereto, and in some example embodiments, the wiring structure 310 may include a greater number of vias than three and/or a greater number of wirings than three sequentially stacked in the vertical direction.

The first via 170 may contact an upper surface or a lower surface of the through electrode 130, and may be surrounded by the first bonding layer 160. The first wiring 175 may contact the first via 170, and may be disposed on the first bonding layer 160. A portion of an upper surface or the lower surface of the first wiring 175 may be referred to as a first pad.

The second via 190 may contact an upper surface or a lower surface of the first pad of the first wiring 175, and may be surrounded by the first insulation layer 180. The second wiring 195 may contact the second via 190, and may be disposed on the first insulation layer 180. A portion of an upper surface or the lower surface of the second wiring 195 may be referred to as a second pad.

The third via 210 may contact an upper surface or a lower surface of the second pad of the second wiring 195, and may be surrounded by the second insulation layer 200. The third wiring 215 may contact the third via 210, and may be disposed on the second insulation layer 200. A portion of an upper surface or the lower surface of the third wiring 215 may be referred to as a third pad.

Each of the first to third vias 170, 190 and 210 and the first to third wirings 175, 195 and 215 may include a metal, e.g., copper, aluminum, etc.

FIG. 1 shows an example in which the first to third vias 170, 190 and 210 and the first to third wirings 175, 195 and 215 are arranged by the same layout on the first and second surfaces 112 and 114 of the core 110, respectively. However, example embodiments are not limited thereto, and in some example embodiment may be arranged by different layouts from each other. That is, FIG. 1 shows an example in which the first to third vias 170, 190 and 210 and the first to third wirings 175, 195 and 215 are arranged symmetrically with respect to a line passing through the center of the core 110 in the vertical direction. However, example embodiments are not limited thereto.

The first and second protective layers 222 and 224 may be disposed on lower and upper surfaces of the second insulation layers 220, respectively, and may cover the third wirings 215. A second opening 225 may expose the third pad of the third wiring 215 on the lower surface of the second insulation layer 220 or on the upper surface of the second insulation layer 220. Each of the first and second protective layers 222 and 224 may include an insulating material, e.g., solder resist (SR).

In example embodiments, the package substrate 100 may be, e.g., a printed circuit board (PCB).

As illustrated above, the recesses 150 may be disposed in the first and second surfaces 112 and 114, respectively, of the core 110 and the first bonding layer 160 may fill the recesses 150, and thus a total area of the first bonding layer 160 contacting the first and second surfaces 112 and 114 of the core 110 may increase. Thus, as compared to the related art in which a bonding layer is formed on surfaces of the core that are flat and have no recesses thereon, a portion of the first bonding layer 160 in the recess 150 may have a greater bonding force to the core 110.

If the surfaces of the core including glass are flat as in the related art, the bonding layer contacting the surfaces of the core and including another material different from glass may not be tightly bonded to the core and may be delaminated from the core.

However, by contrast, in example embodiments, the recesses 150 may be disposed in the first and second surfaces 112 and 114 of the core 110 and filled with the first bonding layer 160 so that the contacting area between the first bonding layer 160 and the core 110 may increase and that the bonding force between the portion of the first bonding layer 160 in the recess 150 and the core 110 may increase. Accordingly, even if delamination occurs between a portion of the first bonding layer 160 and the core 110, a total bonding force between the first bonding layer 160 and the core 110 may increase.

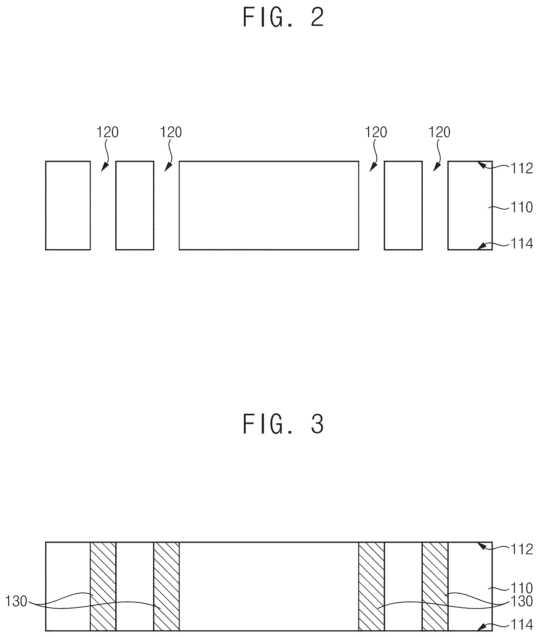

FIGS. 2 to 6 are cross-sectional views illustrating a method of manufacturing a package substrate in accordance with example embodiments.

Referring to FIG. 2, a via hole 120 may be formed through a core 110 having a first surface 112 and a second surface 114 opposite to each other in the vertical direction.

In example embodiments, the core 110 may include glass.

In example embodiments, the via hole 120 may be formed using, e.g., a laser drill, and a plurality of via holes 120 may be spaced apart from each other in the horizontal direction.

Referring to FIG. 3, a first seed layer may be formed on the first and second surfaces 112 and 114 and inner walls of the via holes 120, e.g., an electroplating process or an electroless plating process may be performed to form a through electrode layer on a the first seed layer to fill the via holes 120, and a planarization process may be performed on the through electrode layer and the first seed layer until the first and second surfaces 112 and 114 of the core 110 are exposed.

Thus, a through electrode 130 may be formed in each of the via holes 120 extending through the core 110 in the vertical direction.

In example embodiments, the planarization process may include a chemical mechanical polishing process.

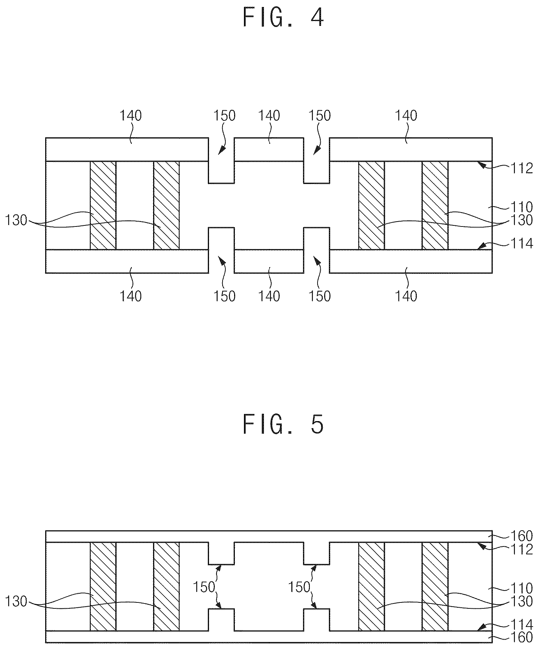

Referring to FIG. 4, first masks 140 may be formed on the first and second surfaces 112 and 114, respectively, to cover upper and lower surfaces, respectively, of the through electrodes 130, and a portion of the core 110 not covered by the first masks 140 may be removed to form recesses 150.

In an example embodiment, the recesses 150 may be formed by an etching process. In some example embodiments, the recesses 150 may be formed by a drilling process using, e.g., a laser drill.

In example embodiments, the recesses 150 may be formed to be spaced apart from each other in the horizontal direction at upper portions of the core 110 and/or at lower portions of the core 110. Each of the recesses 150 may have a shape of, e.g., a circle, an ellipse, a polygon, a polygon with rounded corners, etc., in a plan view. In an example embodiment, a width in the horizontal direction of each of the recesses 150 may be substantially constant in the vertical direction, and thus a sidewall of each of the recesses 150 may extend in the vertical direction.

Referring to FIG. 5, the first mask 140 may be removed to expose the first and second surfaces 112 and 114 of the core 110 and the upper and lower surfaces of the through electrodes 130, and first bonding layers 160 may be formed on the first and second surfaces 112 and 114, respectively, of the core 110 and the upper and lower surfaces of the through electrodes 130, respectively.

In example embodiments, the first bonding layer 160 may be formed by, e.g., a lamination process or a coating process.

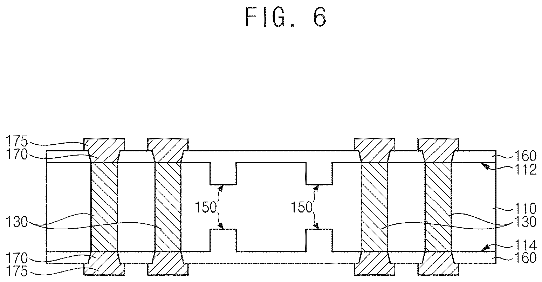

Referring to FIG. 6, the first bonding layers 160 may be partially removed to form first openings exposing the upper and lower surfaces of the through electrodes 130, respectively, second seed layers may be formed on the upper and lower surfaces of the through electrodes 130, respectively, and the first bonding layers 160, respectively, second masks having second openings, respectively, overlapping the through electrode 130 in the vertical direction may be formed on the second seed layers, respectively, conductive layers may be formed on the second seed layers, respectively, by e.g., an electroplating process or an electroless plating process, and the second masks may be removed.

Thus, a first via 170 and a first wiring 175 may be formed in each of the second opening to contact the lower surface or the upper surface of the through electrode 130.

Referring to FIG. 1 again, processes substantially the same as or similar to those illustrated with respect to FIG. 6 may be performed to form a first insulation layer 180 and a second insulation layer 200, a second via 190 and a third via 210, and a second wiring 195 and a third wiring 215.

The first and second insulation layers 180 and 200 stacked in the vertical direction may form an insulation layer structure 300, and the first to third vias 170, 190 and 210 and the first to third wirings 175, 195 and 215 may form a wiring structure 310.

A first protective layer 222 and a second protective layer 224 may be formed on the second insulation layers 200, respectively, to cover the third wirings 215, and portions of the first and second protective layers 222 and 224 may be removed to form third openings 225 exposing surfaces of portions of the third wirings 215, respectively, to complete the manufacturing of the package substrate 100.

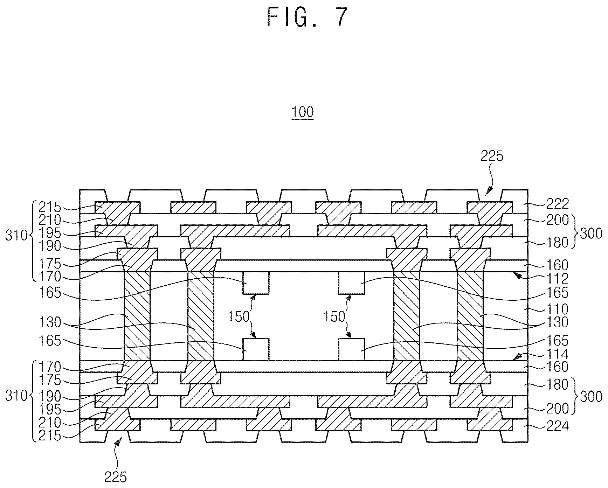

FIG. 7 is a cross-sectional view illustrating a package substrate in accordance with example embodiments. The package substrate illustrated in FIG. 7 may be substantially the same as or similar to that of FIG. 1, except for further including a second bonding layer, and thus repeated explanations are omitted herein for conciseness.

Referring to FIG. 7, the package substrate 100 may include second bonding layers 165 (also referred to as a first bonding sublayer in the claims) in addition to the first bonding layers 160 (also referred to as a second bonding sublayer in the claims).

The first bonding layers 160 may contact flat portions of the first and second surfaces 112 and 114, respectively, of the core 110, and the second bonding layers 165 may be disposed in the recesses 150, respectively, to contact the core 110 and upper or lower surfaces, respectively, of the first bonding layers 160.

In example embodiments, the second bonding layer 165 may include an organic insulating material different from an organic insulating material of the first bonding layer 160. For example, the second bonding layer 165 may include an organic insulating material having a high bonding force to glass used in the core 110 and to a polymer of the first bonding layer 160.

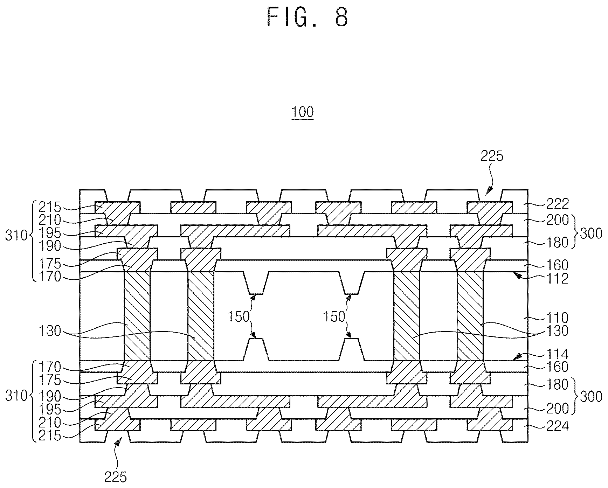

FIGS. 8 to 10 are cross-sectional views illustrating package substrates in accordance with example embodiments. Each of the package substrates illustrated in FIGS. 8-10 may be substantially the same as or similar to the package substrate of FIG. 1, except for the shape of the recess, and thus repeated explanations are omitted herein for conciseness. The shape of the recess illustrated in FIGS. 8-10 may also be applied to the package substrate of FIG. 7.

Referring to FIG. 8, a width in the horizontal direction of the recess 150 may gradually decrease as a distance from each of the first and second surfaces 112 and 114 of the core 110 increases.

Thus, a sidewall of the recess 150 may be slanted with respect to the vertical direction.

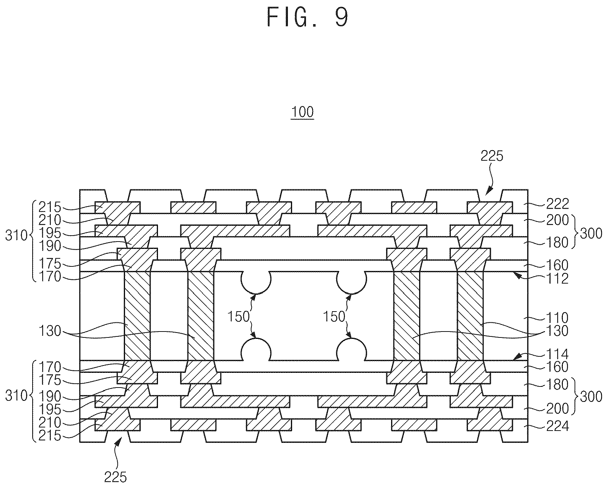

Referring to FIG. 9, a cross-section in the vertical direction of the recess 150 may have a shape of a semi-circle.

For example, the recess 150 may be formed by an isotropic etching process, e.g., a wet etching process, so that a width in the horizontal direction of the recess 150 may gradually increase and decrease again as a distance from each of the first and second surfaces 112 and 114 of the core 110 increases.

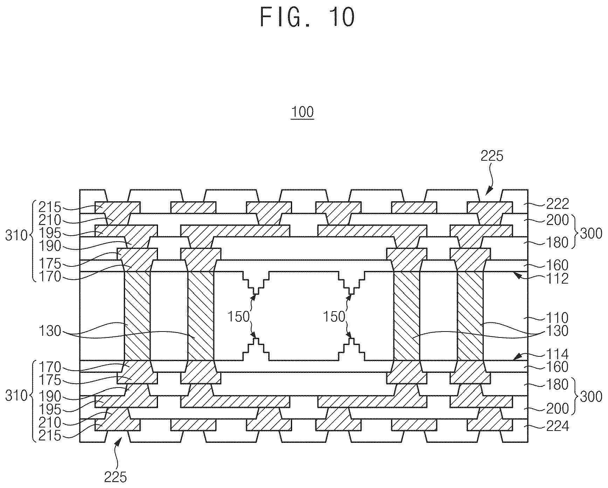

Referring to FIG. 10, a width in the horizontal direction of the recess 150 may decrease in a stepwise manner as a distance from each of the first and second surfaces 112 and 114 of the core 110 increases.

Thus, a cross-section of the recess 150 in the vertical direction may have a staircase shape.

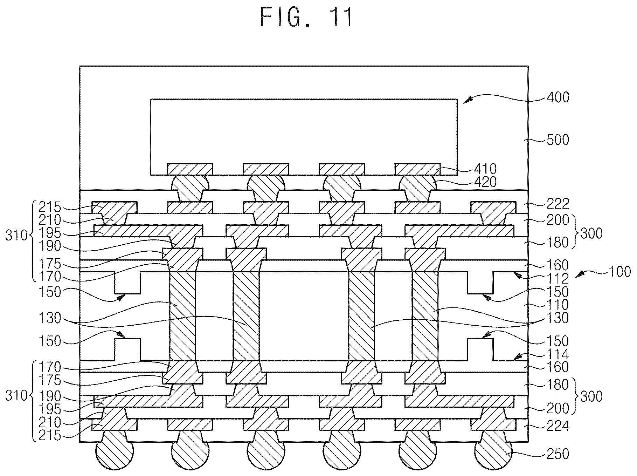

FIG. 11 is a cross-sectional view illustrating a semiconductor package in accordance with example embodiments. This semiconductor package may include the package substrate of FIG. 1, and thus repeated explanations are omitted herein for conciseness. The semiconductor package illustrated in FIG. 11 according to some example embodiments may include any one of the package substrates shown in FIGS. 7 to 10.

Referring to FIG. 11, the semiconductor package may include the package substrate 100, a semiconductor chip 400 on the first protective layer 222 of the package substrate 100, a first conductive connection member 420 between the first protective layer 222 and the semiconductor chip 400, a molding member 500 disposed on the first protective layer 222 and covering the semiconductor chip 400 and the first conductive connection member 420, and a second conductive connection member 250 on a lower surface of the second protective layer 224 of the package substrate 100.

The semiconductor chip 400 may be a logic chip including logic device or a memory chip including a memory device. A conductive pad 410 may be disposed on a surface of the semiconductor chip 400, and the first conductive connection member 420 may contact a lower surface of the conductive pad 410 and an upper surface of the third pad of the third wiring 215 exposed by the third opening 225 in the first protective layer 222. The first conductive connection member 420 may be a conductive bump or a conductive ball including, e.g., solder.

The molding member 500 may include, e.g., epoxy molding compound (EMC).

The second conductive connection member 250 may contact a lower surface of the third pad of the third wiring 215 exposed by the third opening 225 in the second protective layer 224. The second conductive connection member 250 may be a conductive bump or a conductive ball including, e.g., solder.

In an example embodiment, the recesses 150 on the first and second surfaces 112 and 114, respectively, of the core 110 of the package substrate 100 may not overlap the semiconductor chip 400 in the vertical direction.

As illustrated above with reference to FIG. 1, the bonding force between the core 110 and the first bonding layer 160 may increase by the recesses 150, and thus the semiconductor package including the package substrate 100 may have enhanced structural stability and electrical characteristics.

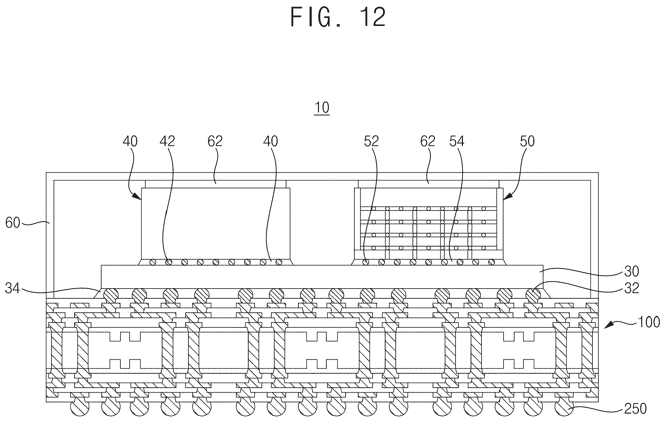

FIG. 12 is a cross-sectional view illustrating an electronic device in accordance with example embodiments. The electronic device may include the package substrate shown in FIG. 1, and thus repeated explanations are omitted herein for conciseness. This electronic device may include any one of the package substrates shown in FIGS. 7 to 10.

Referring to FIG. 12, an electronic device 10 may include a package substrate 20, an interposer 30, a first semiconductor device 40 and a second semiconductor device 50. The electronic device 10 may further include a first underfill member 34, a second underfill member 44, and a third underfill member 54, a heat slug 60 and a heat dissipation member 62.

In example embodiments, the electronic device 10 may be a memory module having a 2.5D package structure, and thus may include the interposer 30 for electrically connecting the first and second semiconductor devices 40 and 50 to each other.

In example embodiments, the first semiconductor device 40 may include a logic device, and the second semiconductor device 50 may include a memory device. The logic device may be an application-specific integrated circuit (ASIC) chip including, e.g., a central processing unit (CPU), a graphics processing unit (GPU), a micro-processor, a microcontroller, an application processor (AP), a digital signal processing core, etc. The memory device may be a semiconductor package such as an HBM package.

The interposer 30 may be mounted on the package substrate 20 through a third conductive connection member 32. In example embodiments, a planar area of the interposer 30 may be smaller than a planar area of the package substrate 20. The interposer 30 may be disposed within an area of the package substrate 20 in a plan view.

The interposer 30 may be a silicon interposer or a redistribution interposer having a plurality of wirings therein. The first semiconductor device 40 and the second semiconductor device 50 may be connected to each other through the wirings in the interposer 30 or electrically connected to the package substrate 20 through the third conductive connection member 32. The third conductive connection member 32 may include, e.g., a micro-bump. The silicon interposer may provide a high-density interconnection between the first and second semiconductor devices 40 and 50.

The first semiconductor device 40 may be disposed on the interposer 30. The first semiconductor device 40 may be mounted on and bonded with the interposer 30 by a flip chip bonding process. In this case, the first semiconductor device 40 may be mounted on the interposer 30 such that an active surface on which conductive pads are formed may face downwardly toward the interposer 30. The conductive pads of the first semiconductor device 40 may be electrically connected to conductive pads of the interposer 30 through a fourth conductive connection member 42. For example, the fourth conductive connection member 42 may include, e.g., a micro-bump.

In some example embodiments, the first semiconductor device 40 may be mounted on the interposer 30 by a wire bonding process, and in this case, the active surface of the first semiconductor device 40 may face upwardly.

The second semiconductor device 50 may be disposed on the interposer 30, and may be spaced apart from the first semiconductor device 40 in the horizontal direction. The second semiconductor device 50 may be mounted on and bonded with the interposer 30 by, e.g., a flip chip bonding process. In this case, conductive pads of the second semiconductor device 50 may be electrically connected to conductive pads of the interposer 30 by a fifth conductive connection member 52.

Although a single first semiconductor device 40 and a single second semiconductor device 50 are disposed on the interposer 30, example embodiments are not be limited thereto, and in some example embodiments, a plurality of first semiconductor devices 40 and/or a plurality of second conductive devices 50 may be disposed on the interposer 30.

In example embodiments, the first underfill member 34 may fill a space between the interposer 30 and the package substrate 20, and the second and third underfill members 44 and 54 may fill a space between the first semiconductor device 40 and the interposer 30 and a space between the second semiconductor device 50 and the interposer 30, respectively.

The first to third underfill members 34, 44 and 54 may include a material having a relatively high fluidity to effectively fill a small space between the first and second semiconductor devices 40 and 50 and the interposer 30 and a small space between the interposer 30 and the package substrate 20. For example, each of the first and second underfill members34, 44 and 54 may include an adhesive containing an epoxy material.

The semiconductor device 50 may include a buffer die and a plurality of memory dies sequentially stacked on the buffer die. The buffer die and the memory dies may be electrically connected to each other by through electrodes, e.g., TSVs, and the through electrodes may be electrically connected to each other by conductive bonding pads. Data signals and control signals may be transferred to the buffer die and the memory dies by the through electrodes.

In example embodiments, the heat slug 60 may be formed on the package substrate 20 to thermally contact the first and second semiconductor devices 40 and 50. The heat dissipation member 62 may be disposed on an upper surface of each of the first and second semiconductor devices 40 and 50, and may include, e.g., thermal interface material (TIM). The heat slug 60 may thermally contact the first and second semiconductor devices 40 and 50 via the heat dissipation member 62.

In an example embodiment, the recesses 150 on the first and second surfaces 112 and 114 of the core 110 in the package substrate 100 may not overlap the first and second semiconductor devices 40 and 50 in the vertical direction.

The electronic device 10 may be mounted on a module substrate through a second conductive connection member 250 to form a memory module.

The foregoing is illustrative of example embodiments and is not to be construed as limiting thereof. Although a few example embodiments have been described with reference to the drawings, those skilled in the art will readily appreciate that many modifications are possible in example embodiments without materially departing from the novel teachings and advantages of the present disclosure. Accordingly, all such modifications are intended to be included within the scope of example embodiments as defined in the claims.

## Claims

1. A package substrate comprising:
a core having a first surface and a second surface that is opposite to the first surface in a vertical direction, the core including glass and a first recess in the first surface;
a first bonding layer contacting the first surface of the core and filling the first recess;
a through electrode extending from the first surface through the core in the vertical direction, the through electrode being spaced apart from the first recess in a horizontal direction;
a first wiring structure on the first bonding layer and contacting the through electrode;
a first insulation layer structure on the first bonding layer and at least partially covering the first wiring structure; and
a first protective layer on the first insulation layer structure and covering an upper surface of a first portion of the first wiring structure.

2. The package substrate according to claim 1, wherein the first surface and the second surface are substantially flat.

3. The package substrate according to claim 1 or 2, wherein a width in the horizontal direction of the first recess is substantially constant in the vertical direction.

4. The package substrate according to claim 1 or 2, wherein a width in the horizontal direction of the first recess gradually decreases as a distance from the first surface of the core increases in the vertical direction.

5. The package substrate according to claim 1 or 2, wherein a width in the horizontal direction of the first recess gradually decreases and increases again as a distance from the first surface of the core increases in the vertical direction.

6. The package substrate according to any one of claims 1, 2 or 4, wherein a cross-section in the vertical direction of the first recess has a staircase shape.

7. The package substrate according to any one of claims 1 to 6, further comprising a plurality of first recesses that are spaced apart from each other in the horizontal direction, the first recess being one of the plurality of first recesses.

8. The package substrate according to any one of claims 1 to 7, wherein the first bonding layer includes epoxy, and the first insulation layer structure includes Ajinomoto build-up film.

9. The package substrate according to any one of claims 1 to 8, wherein the core further includes a second recess in the second surface of the core.

10. The package substrate according to claim 9, wherein the through electrode extends from the first surface, through the core, to the second surface in the vertical direction, and
wherein the package substrate further comprises:
a second bonding layer contacting the second surface of the core and filling the second recess;
a second wiring structure on the second bonding layer and contacting the through electrode;
a second insulation layer structure on the second bonding layer and at least partially covering the second wiring structure; and
a second protective layer on the second insulation layer structure and covering a lower surface of a portion of the second wiring structure.

11. The package substrate according to claim 9 or 10, wherein the first recess and the second recess are arranged symmetrically with respect to a line passing through the core in the horizontal direction.

12. The package substrate of any one of claims 1 to 11, wherein:
the first bonding layer comprises a first bonding sublayer and a second bonding sublayer,
the first bonding sublayer is in the first recess, the first bonding sublayer including a first organic insulating material, and
the second bonding sublayer contacts the first surface of the core and an upper surface of the first bonding sublayer, the second bonding sublayer including a second organic insulating material that is different from the first organic insulating material.

13. A semiconductor package comprising:
a package substrate according to any one of the preceding claims;
a semiconductor chip on the package substrate, the semiconductor chip including a conductive pad;
a first conductive connection member contacting the conductive pad of the semiconductor chip, the conductive connection member being electrically connected to a second portion of the first wiring structure; and
a molding member on the package substrate and covering the semiconductor chip and a sidewall of the first conductive connection member.
